# EUROPEAN PATENT SPECIFICATION

(11) **EP 4 181 189 B1**
(45) Date of publication and mention of the grant of the patent: **21.05.2025**
(21) Application number: 21927490.9
(22) Date of filing: 11.08.2021
(51) Int. Cl.: H01L 21/60, H01L 23/488

(54) **SEMICONDUCTOR STRUCTURE AND PREPARATION METHOD THEREFOR**
HALBLEITERSTRUKTUR UND HERSTELLUNGSVERFAHREN DAFÜR
STRUCTURE SEMI-CONDUCTRICE ET SON PROCÉDÉ DE PRÉPARATION

(30) Priority: 25.02.2021 CN 202110212890
(43) Date of publication of application: 17.05.2023
(73) Proprietor: Changxin Memory Technologies, Inc., Hefei, Anhui 230601 (CN)
(72) Inventor: ZUO, Mingxing, Hefei, Anhui 230601 (CN)
(74) Representative: Lavoix
(86) International application number: PCT/CN2021/112029
(87) International publication number: WO 2022/179061

(56) References cited:
- CN-A- 111 312 666
- CN-B- 104 425 632
- CN-U- 205 282 469
- CN-U- 206 532 771
- JP-A- 2006 173 416
- US-A1- 2006 108 673
- US-A1- 2019 279 937
- US-A1- 2023 119 406

## Description

### Cross-Reference to Related Applications

The present disclosure claims the priority to Chinese Patent Application No. 202110212890.2, titled "SEMICONDUCTOR STRUCTURE AND MANUFACTURING METHOD THEREOF", filed on February 25, 2021.

### Technical Field

The present disclosure relates to the technical field of semiconductors, and in particular to a semiconductor structure and a manufacturing method thereof.

### Background

In the packaging process of an existing memory thin die stack, a die, an adhesive layer and a solder mask (SR for short, alias "green mask") on a substrate are in direct contact with each other. In the art, the substrate (including the solder mask) and the die are designed thinner and thinner. When the die bends itself, or deforms due to external force, or undergoes temperature cycling reliability (TC reliability) detection, an edge position where the die is connected with the substrate is prone to die crack or substrate crack due to stress concentration. CN 111 312 666 A describes a semiconductor package structure using a lead frame, an adhesive layer, and a molding compound. The adhesive layer connects the die to the lead frame and covers sharp corners to mitigate stress.

### Summary

One aspect of the embodiments of the present disclosure provides a semiconductor structure, including a substrate, a die and a first adhesive layer, wherein a surface of the substrate is provided with an insulation layer; the die is arranged on a surface of the insulation layer via the first adhesive layer; the insulation layer is provided with at least one hole slot, the hole slot being defined as a recess, trench or void in the insulation layer, with a geometry corresponding to an edge of the first adhesive layer; a position of the at least one hole slot corresponds to at least a part of an edge of the first adhesive layer; a second adhesive layer is arranged in the at least one hole slot; at least a part of a surface of the second adhesive layer is connected with the first adhesive layer; and an elasticity modulus of the second adhesive layer is smaller than an elasticity modulus of the first adhesive layer.

Another aspect of the embodiments of the present disclosure provides a method of manufacturing a semiconductor structure, including: providing a substrate, wherein a surface of the substrate is provided with an insulation layer; forming at least one hole slot which runs through the insulation layer on the insulation layer; forming a second adhesive layer in the at least one hole slot; arranging a die on a surface of the insulation layer via a first adhesive layer, wherein a position of the at least one hole slot corresponds to at least a part of an edge of the first adhesive layer, at least a part of a surface of the second adhesive layer is connected with the first adhesive layer; and an elasticity modulus of the second adhesive layer is smaller than an elasticity modulus of the first adhesive layer; and forming a packaging layer on the surface of the insulation layer, wherein the die and the first adhesive layer are packaged in the packaging layer.

### Brief Description of the Drawings

FIGS. 1-4 are schematic structures of a semiconductor structure in a plurality of steps of a method of manufacturing a semiconductor structure according to an exemplary embodiment;
FIG. 5 is a top view of the semiconductor structure in steps as shown in FIG. 4;
FIGS. 6-11 are schematic structures of a semiconductor structure in a plurality of steps of a method of manufacturing a semiconductor structure according to an exemplary embodiment;
FIG. 12 is a top view of a semiconductor structure in one step of a method of manufacturing a semiconductor structure according to another exemplary embodiment;
FIG. 13 is a schematic structure of a semiconductor structure according to another exemplary embodiment; and
FIG. 14 is a schematic structure of a semiconductor structure according to another exemplary embodiment;
FIG. 15 shows a flowchart of a method of manufacturing a semiconductor structure according to an exemplary embodiment;
FIG. 16 shows a flowchart of forming at least one hole slot in a method of manufacturing a semiconductor structure according to an exemplary embodiment;
FIG. 17 shows a flowchart of forming a second adhesive layer in a method of manufacturing a semiconductor structure according to an exemplary embodiment.

### Detailed Description

Exemplary embodiments will be described below more comprehensively with reference to the accompanying drawings. However, the exemplary embodiments can be implemented in a plurality of forms and should not be construed as being limited to embodiments described herein. On the contrary, these embodiments are provided such that the present disclosure is more comprehensive and complete, and fully conveys the concept of the exemplary embodiments to those skilled in the art. The same reference numerals in the figures indicate the same or similar structures, and thus their detailed descriptions will be omitted.

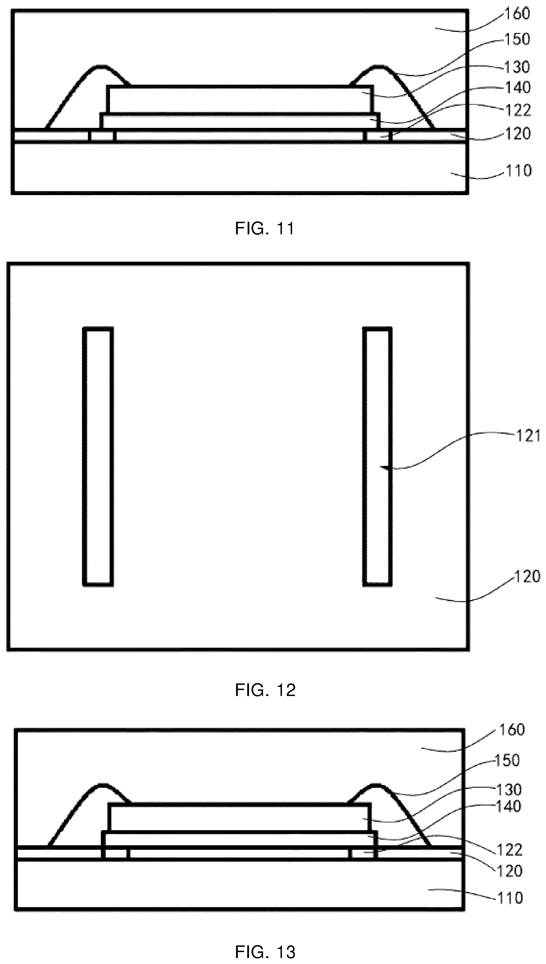

Referring to FIG. 11, FIG. 11 representatively shows a schematic structure of a semiconductor structure proposed by the present disclosure. In the exemplary embodiment, the semiconductor structure proposed by the present disclosure is described by taking its application to a packaging structure of a memory thin die stack as an example. It is understandable for those skilled in the art that, in order to apply the relevant design of the present disclosure to other types of semiconductor structures, various modifications, additions, substitutions, deletions or other changes may be made to the following specific embodiments, but such changes are still within the scope of the principle of the semiconductor structure proposed by the present disclosure.

As shown in FIG. 11, in the embodiment, the semiconductor structure proposed by the present disclosure mainly includes a substrate 110, a die 130 and a first adhesive layer 140. Specifically, a surface of the substrate 110 is provided with an insulation layer 120. The die 130 is arranged on a surface of the insulation layer 120 via the first adhesive layer 140. The insulation layer 120 is provided with at least one hole slot 121, and a position of the at least one hole slot 121 corresponds to an edge of the first adhesive layer 140. And, a second adhesive layer 122 is arranged in the at least one hole slot 121, and at least a part of a surface of the second adhesive layer 122 is connected with the first adhesive layer 140. On this basis, an elasticity modulus of the second adhesive layer 122 is smaller than an elasticity modulus of the first adhesive layer 140. Via the above design, the semiconductor structure proposed by the present disclosure can optimize the stress distribution of an edge where the die 130 is connected with the substrate 110 (including the insulation layer 120 arranged on the surface of the substrate 110), such that the semiconductor structure is difficult to generate crack at the edge where the die 130 is connected with the substrate 110 during bending or deformation.

Optionally, referring to FIG. 11, in the embodiment, the at least one hole slot 121 may run through the insulation layer 120. In other embodiments, the at least one hole slot 121 may also not run through the insulation layer 120, for example, the at least one hole slot 121 is only opened on an upper surface of the insulation layer 120.

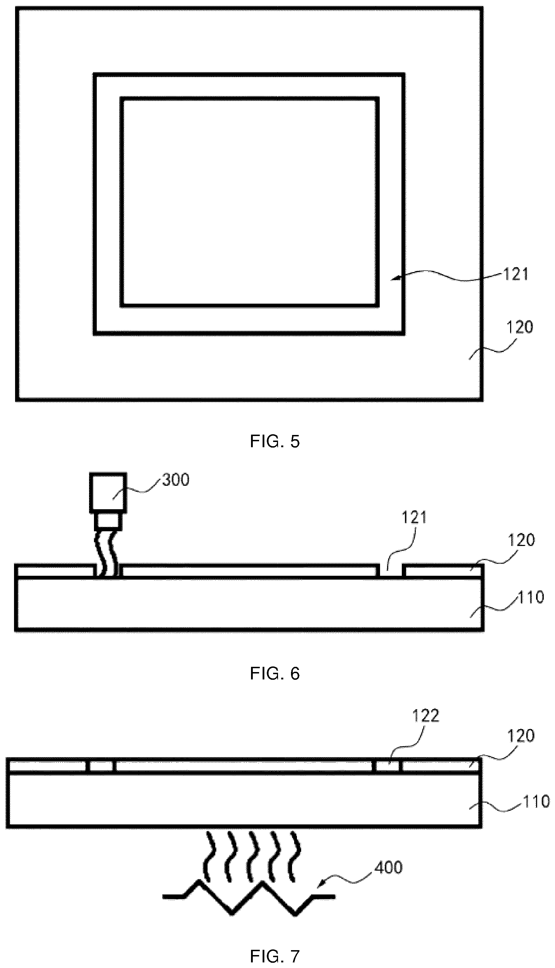

Optionally, referring to FIG. 5, FIG. 5 representatively shows a top view of the semiconductor structure in forming the at least one hole slot 121, and in the embodiment, one hole slot of the at least one hole slot 121 may approximately be an annular closed structure, such that the hole slot of the at least one hole slot 121 corresponds to the whole edge of the first adhesive layer 140. Via the above design, the semiconductor structure proposed by the present disclosure can optimize the stress distribution of the whole position of the edge where the die 130 is connected with the substrate 110, such that the whole edge where the die 130 is connected with the substrate 110 is difficult to generate crack.

Further, referring to FIG. 5, based on the design that the hole slot of the at least one hole slot 121 is an annular closed structure, in the embodiment, the first adhesive layer 140 may be approximately rectangular and the edge of the first adhesive layer 140 has four side edges. On this basis, the hole slot of the at least one hole slot 121 may be approximately arranged in a form of a rectangular ring. In other embodiments, based on the design that the hole slot of the at least one hole slot 121 corresponds to the whole edge of the first adhesive layer 140, when the first adhesive layer 140 is in a shape of a circle, a triangle, a trapezoid or the like, the hole slot of the at least one hole slot 121 may be arranged in corresponding forms of a circular ring, a triangular ring, a trapezoidal ring and the like, which is not limited to the embodiment.

Optionally, as shown in FIG. 11, in the embodiment, on the surface of the substrate 110, an outer side edge of an orthographic projection of the at least one hole slot 121 may be located outside an edge of an orthographic projection of the first adhesive layer 140. Accordingly, the second adhesive layer 122 arranged in the at least one hole slot 121 can extend to an outer side of the edge of the first adhesive layer 140, such that the present disclosure can optimize the stress distribution of a part of a region, located on the outer side of the edge of the first adhesive layer 140, of the substrate 110, thereby further preventing crack of a relevant region.

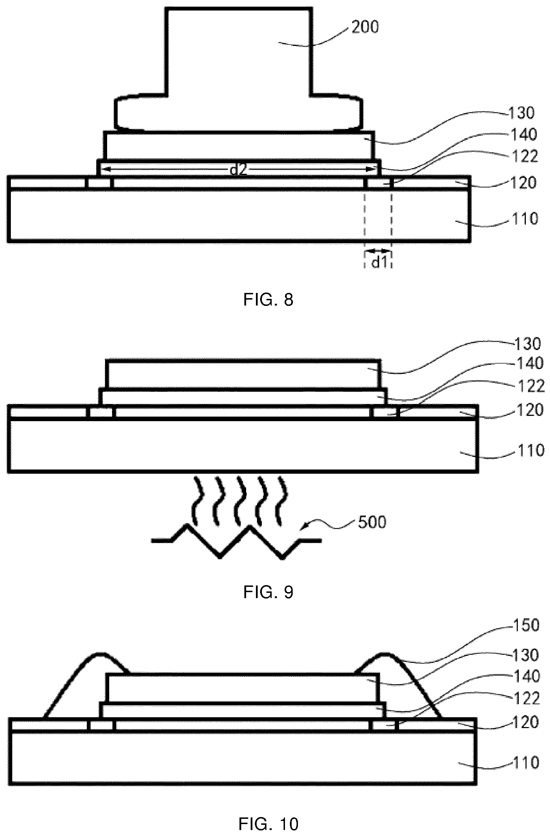

Optionally, referring to FIG. 9, FIG. 9 representatively shows a schematic structure of the semiconductor structure in arranging the die 130, and in the embodiment, a notch width d1 of the at least one hole slot 121 may be 5%-10% of a width d2 of the first adhesive layer 140, for example, 5%, 6.5%, 8% and 10%. Accordingly, the present disclosure selects a width proportion of the hole 121 to the first adhesive layer 140 as a reasonable scope, thereby preventing the die 130 from overall viscosity inefficiency due to excessive notch width d1 of the at least one hole slot 121, and preventing the condition that the effects of better stress distribution optimization and crack prevention cannot be realized due to too small notch width d1 when the semiconductor structure deforms. In other embodiments, the notch width d1 of the at least one hole slot 121 may be smaller than 5% or greater than 10% of the width d2 of the first adhesive layer 140, for example, 4.5%, 11% and the like, which is not limited to the embodiment.

Optionally, in the embodiment, the elasticity modulus of the second adhesive layer 122 may be smaller than the elasticity modulus of the insulation layer 120. Accordingly, a corresponding position (for example, a position adjoining the at least one hole slot 121, namely, a position corresponding to the edge of the first adhesive layer 140) of the insulation layer 120 may be difficult to generate crack. In other embodiments, on the basis of ensuring that the elasticity modulus of the second adhesive layer 122 is smaller than the elasticity modulus of the first adhesive layer 140, the elasticity modulus of the second adhesive layer 122 may also be equal to or greater than the elasticity modulus of the insulation layer 120, which is not limited to the embodiment.

Optionally, in the embodiment, the elasticity modulus of the second adhesive layer 122 may be smaller than the elasticity modulus of the die 130. Accordingly, a corresponding position (for example, an edge position) of the die 130 may be difficult to generate crack. In other embodiments, on the basis of ensuring that the elasticity modulus of the second adhesive layer 122 is smaller than the elasticity modulus of the first adhesive layer 140, the elasticity modulus of the second adhesive layer 122 may also be equal to or greater than the elasticity modulus of the die 130, which is not limited to the embodiment.

Optionally, in the embodiment, a coefficient of thermal expansion of the second adhesive layer 122 may be smaller than a coefficient of thermal expansion of the first adhesive layer 140. Accordingly, when the semiconductor structure is heated to deform, as the second adhesive layer 122 has a lower coefficient of thermal expansion relative to the first adhesive layer 140, the first adhesive layer 140 can be prevented from crack caused by generating, by the second adhesive layer, same or even larger expansive deformation as the first adhesive layer 140. In other embodiments, under the premise of ensuring that the present disclosure optimizes the stress distribution of a relevant position via the arrangement of the second adhesive layer 122, the coefficient of thermal expansion of the second adhesive layer 122 may also be greater than or equal to the coefficient of thermal expansion of the first adhesive layer 140, which is not limited to the embodiment.

Further, based on the design that the coefficient of thermal expansion of the second adhesive layer 122 is smaller than the coefficient of thermal expansion of the first adhesive layer 140, in the embodiment, the coefficient of thermal expansion of the second adhesive layer 122 may also be smaller than the coefficient of thermal expansion of the insulation layer 120. Accordingly, when the semiconductor structure is heated to deform, as the second adhesive layer 122 has a lower coefficient of thermal expansion relative to the insulation layer 120, the insulation layer 120 may be prevented from crack caused by generating, by the second adhesive layer 122, same or even larger expansive deformation as the insulation layer 120. In other embodiments, on the basis that the coefficient of thermal expansion of the second adhesive layer 122 is smaller than the coefficient of thermal expansion of the first adhesive layer 140, the coefficient of thermal expansion of the second adhesive layer 122 may also be greater than or equal to the coefficient of thermal expansion of the insulation layer 120, which is not limited to the embodiment.

Further, based on the design that the coefficient of thermal expansion of the second adhesive layer 122 is smaller than the coefficient of thermal expansion of the first adhesive layer 140, in the embodiment, the coefficient of thermal expansion of the second adhesive layer 122 may also be smaller than the coefficient of thermal expansion of the die 130. Accordingly, when the semiconductor structure is heated to deform, as the second adhesive layer 122 has a lower coefficient of thermal expansion relative to the die 130, the die 130 may be prevented from crack caused by generating, by the second adhesive layer, same or even larger expansive deformation as the die 130. In other embodiments, on the basis that the coefficient of thermal expansion of the second adhesive layer 122 is smaller than the coefficient of thermal expansion of the first adhesive layer 140, the coefficient of thermal expansion of the second adhesive layer 122 may also be greater than or equal to the coefficient of thermal expansion of the die 130, which is not limited to the embodiment.

Optionally, in the embodiment, a bonding strength between the first adhesive layer 140 and the second adhesive layer 122 may be smaller than a bonding strength between the first adhesive layer 140 and the die 130. Accordingly, when the semiconductor structure deforms, by utilizing the above bonding strength design, the separation of the second adhesive layer 122 from the first adhesive layer 140 may be earlier than the separation of the first adhesive layer 140 from the die 130, therefore, when the deformation is too large to generate thin film structure separation, the separation of the second adhesive layer 122 from the first adhesive layer 140 can be utilized to prevent or slow down the separation of the first adhesive layer 140 from the die 130. In other embodiments, under the premise of ensuring that the present disclosure optimizes the stress distribution of a relevant position via the arrangement of the second adhesive layer 122, the bonding strength between the first adhesive layer 140 and the second adhesive layer 122 may also be greater than or equal to the bonding strength between the first adhesive layer 140 and the die 130, which is not limited to the embodiment.

Optionally, in the embodiment, the bonding strength between the first adhesive layer 140 and the second adhesive layer 122 may be smaller than a bonding strength between the first adhesive layer 140 and the insulation layer 120. Accordingly, when the semiconductor structure deforms, by utilizing the above bonding strength design, the separation of the second adhesive layer 122 from the first adhesive layer 140 may be earlier than the separation of the first adhesive layer 140 from the insulation layer 120, therefore, when the deformation is too large to generate thin film structure separation, the separation of the second adhesive layer 122 from the first adhesive layer 140 can be utilized to prevent or slow down the separation of the first adhesive layer 140 from the insulation layer 120. In other embodiments, under the premise of ensuring that the present disclosure optimizes the stress distribution of the relevant position via the arrangement of the second adhesive layer 122, the bonding strength between the first adhesive layer 140 and the second adhesive layer 122 may also be greater than or equal to the bonding strength between the first adhesive layer 140 and the insulation layer 120, which is not limited to the embodiment.

Optionally, in the embodiment, the material of the second adhesive layer 122 may include silicone gel, epoxy resin adhesive (for example, organosilicon epoxy resin adhesive, Silicon epoxy) and the like.

Based on the above detailed description of the first embodiment of the semiconductor structure proposed by the present disclosure, a second embodiment of the semiconductor structure proposed by the present disclosure will be described below in combination with FIG. 12.

Referring to FIG. 12, FIG. 12 representatively shows a top view of the semiconductor structure in forming the at least one hole slot 121 in the second embodiment. In the second embodiment, the semiconductor structure proposed by the present disclosure adopts a design approximately same as a design of the first embodiment described above, and the design of the second embodiment different from the design of the first embodiment will be described below.

As shown in FIG. 12, in the embodiment, the position of the at least one hole slot 121 corresponds to a part of the edge of the first adhesive layer 140. Accordingly, the present disclosure can optimize the stress distribution of a part of the position of the edge where the die 130 is connected with the substrate 110, such that a part of the edge where the die 130 is connected with the substrate 110 is difficult to generate crack. In other words, in various possible embodiments consistent with the design concept of the semiconductor structure proposed by the present disclosure, the position of the at least one hole slot 121 may correspond to at least a part of the edge of the first adhesive layer 140, such that the present disclosure can optimize the stress distribution of at least a part of the position of the edge where the die 130 is connected with the substrate 110.

Optionally, as shown in FIG. 12, based on the design that the position of the at least one hole slot 121 corresponds to a part of the edge of the first adhesive layer 140, in the embodiment, when the first adhesive layer 140 is approximately rectangular, the at least one hole slot 121 corresponds to one, two or three side edges of the rectangle. Certainly, the at least one hole slot 121 may also correspond to a part of any side edge, or the at least one hole slot 121 may also correspond to four corner parts of the rectangle, separately, both of which are not limited to the embodiment.

Based on the above detailed description of the first embodiment of the semiconductor structure proposed by the present disclosure, a third embodiment of the semiconductor structure proposed by the present disclosure will be described below in combination with FIG. 13.

Referring to FIG. 13, FIG. 13 representatively shows a schematic structure of the semiconductor structure in the third embodiment. In the third embodiment, the semiconductor structure proposed by the present disclosure adopts a design approximately same as a design of the first embodiment described above, and the design of the third embodiment different from the design of the first embodiment will be described below.

As shown in FIG. 13, in the embodiment, on the surface of the substrate 110, an orthographic projection of the at least one hole slot 121 is fully covered by an orthographic projection of the first adhesive layer 140, such that the whole surface of the second adhesive layer 122 is connected with the first adhesive layer 140. In other words, in various possible embodiments consistent with the design concept of the semiconductor structure proposed by the present disclosure, at least a part of the surface of the second adhesive layer 122 is connected with the first adhesive layer 140.

Further, as shown in FIG. 13, based on the design that the orthographic projection of the at least one hole slot 121 is fully covered by the orthographic projection of the first adhesive layer 140, on the surface of the substrate 110, an outer side edge of the orthographic projection of the at least one hole slot 121 may coincide with an edge of the orthographic projection of the first adhesive layer 140.

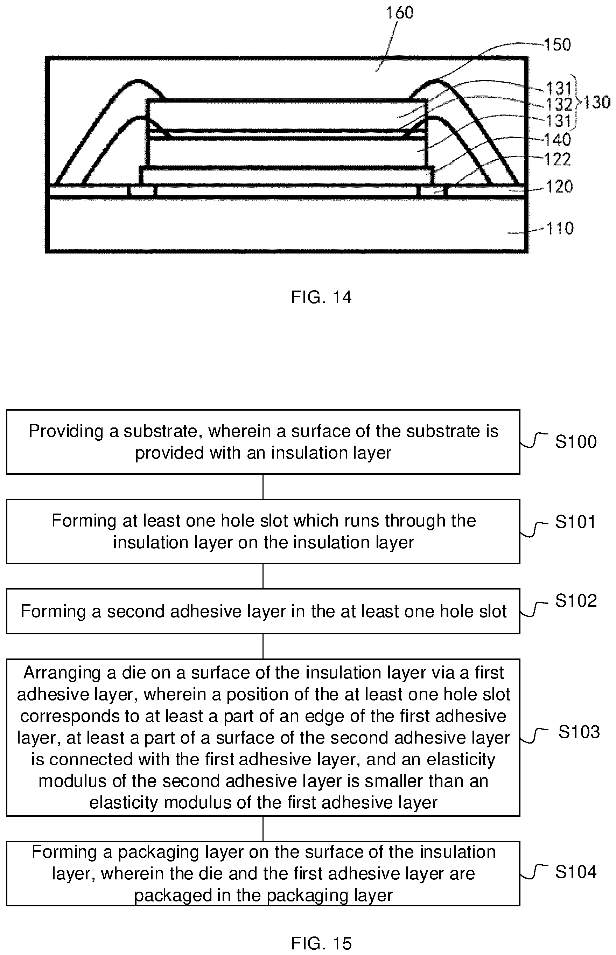

Based on the above detailed description of the first embodiment of the semiconductor structure proposed by the present disclosure, a fourth embodiment of the semiconductor structure proposed by the present disclosure will be described below in combination with FIG. 14.

Referring to FIG. 14, FIG. 14 representatively shows a schematic structure of the semiconductor structure in the fourth embodiment. In the fourth embodiment, the semiconductor structure proposed by the present disclosure adopts a design approximately same as a design of the first embodiment described above, and the design of the fourth embodiment different from the design of the first embodiment will be described below.

As shown in FIG. 14, in the embodiment, the die 130 may adopt a multilayer stack structure, namely, the die includes a plurality of bare dies 131 of an alternate stack and a die attach film 132 (DAF for short). On this basis, the die 130 is still arranged on the first adhesive layer 140 as an integral structure, and specifically, the bare die 131 located at the lowest layer is arranged on the first adhesive layer 140.

For example, the semiconductor structure proposed by the present disclosure may include a packaging layer 160, which is arranged on a surface of the substrate and internally packages the die 130 and the first adhesive layer 140.

For another example, the bare die 131 of the die 130 is bonded with the substrate 110 via a bonding wire 150.

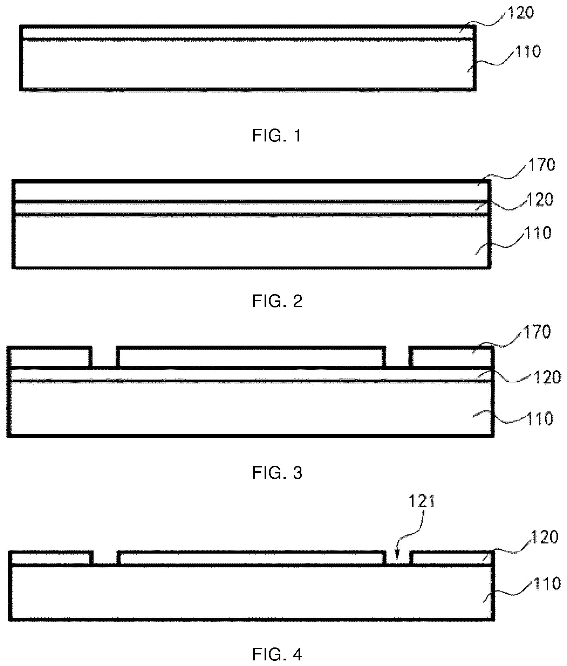

Based on the above detailed description of several exemplary embodiments of the semiconductor structure proposed by the present disclosure, an exemplary embodiment of a method of manufacturing the semiconductor structure proposed by the present disclosure will be described below in combination with FIGS. 1-11.

Referring to FIGS. 1 to 11, FIGS. 1-4 and FIGS. 6-11 representatively show schematic structures of the semiconductor structure in a plurality of steps of the method of manufacturing the semiconductor structure proposed by the present disclosure, respectively. In the exemplary embodiment, the method of manufacturing the semiconductor structure proposed by the present disclosure is described by taking the method of manufacturing the packaging structure applied to a memory thin die stack as an example. It is understandable for those skilled in the art that, in order to apply the relevant design of the present disclosure to other types of semiconductor structures, various modifications, additions, substitutions, deletions or other changes may be made to the following specific embodiments, but such changes are still within the scope of the principle of the method of manufacturing the semiconductor structure proposed by the present disclosure.

As shown in FIGS. 1-11, referring to FIG. 15, in the embodiment, the method of manufacturing the semiconductor structure proposed by the present disclosure mainly includes:
S100: providing a substrate 110, wherein a surface of the substrate 110 is provided with an insulation layer 120;
S101: forming at least one hole slot 121 which runs through the insulation layer 120 on the insulation layer 120;
S102: forming a second adhesive layer 122 in the at least one hole slot 121;
S103: arranging a die 130 on a surface of the insulation layer 120 via a first adhesive layer 140, wherein a position of the at least one hole slot 121 corresponds to at least a part of an edge of the first adhesive layer 140, at least a part of a surface of the second adhesive layer 122 is connected with the first adhesive layer 140, and an elasticity modulus of the second adhesive layer 122 is smaller than an elasticity modulus of the first adhesive layer 140; and
S104: forming a packaging layer 160 on the surface of the insulation layer 120, wherein the die 130 and the first adhesive layer 140 are packaged in the packaging layer 160.

Via the above design, the method of manufacturing the semiconductor structure proposed by the present disclosure can optimize the stress distribution of an edge where the die 130 is connected with the substrate 110 (including the insulation layer 120 arranged on the surface of the substrate 110), such that the semiconductor structure is difficult to generate crack at the edge where the die 130 is connected with the substrate 110 during bending or deformation.

As shown in FIG. 1, FIG. 1 representatively shows a schematic structure of the semiconductor structure in the "providing a substrate 110". In the above step, the semiconductor structure includes the substrate 110 and the insulation layer 120. The insulation layer 120 is arranged on a surface of the substrate 110. It is understandable that in some of the description of the Description, the insulation layer 120 is overall described as a part of the substrate 110, and in a practical process, a finished substrate having the insulation layer 120 can be directly manufactured without departing from the relevant design concept of the present disclosure.

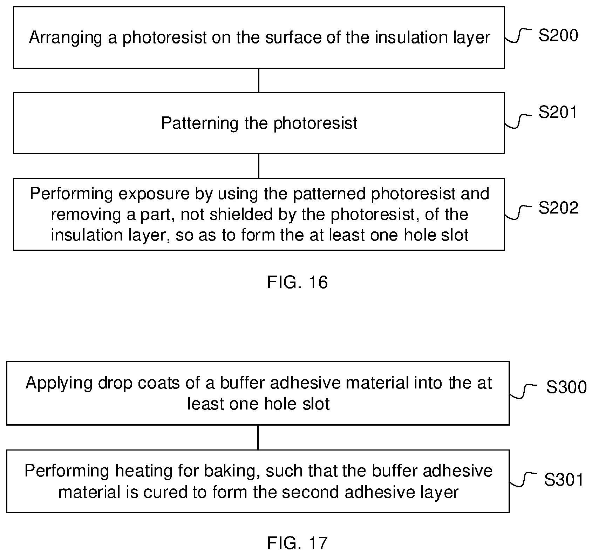

Optionally, as shown in FIGS. 2-4, referring to FIG. 16, in the embodiment, the forming the at least one hole slot 121 may specifically include:
S200: arranging a photoresist 170 on the surface of the insulation layer 120;
S201: patterning the photoresist 170; and
S202: performing exposure by using the patterned photoresist 170 and removing a part, not shielded by the photoresist 170, of the insulation layer 120, so as to form the at least one hole slot 121.

As shown in FIG. 2, FIG. 2 representatively shows a schematic structure of the semiconductor structure in the "arranging the photoresist 170". In the above step, the semiconductor structure includes the substrate 110, the insulation layer 120 and the photoresist 170. The photoresist 170 is coated on the surface of the insulation layer 120.

As shown in FIG. 3, FIG. 3 representatively shows a schematic structure of the semiconductor structure in the "patterning the photoresist 170". In the above step, the semiconductor structure includes the substrate 110, the insulation layer 120 and the patterned photoresist 170. The part, removed via the patterning process, of the photoresist 170 corresponds to a position, needing to arrange the at least one hole slot 121, on the insulation layer 120.

As shown in FIG. 4, FIG. 4 representatively shows a schematic structure of the semiconductor structure in the "performing exposure by using the photoresist 170 to remove a part of the insulation layer 120". In the above step, the semiconductor structure includes the substrate 110 and the remaining insulation layer 120 after the part is removed. The part, not shielded by the photoresist 170, of the insulation layer 120 is removed to form the at least one hole slot 121 which runs through the insulation layer 120, and so far, a process of transferring a pattern of the photoresist 170 onto the insulation layer 120 is finished.

As shown in FIG. 5, FIG. 5 representatively shows a top view of the semiconductor structure in the "performing exposure by using the photoresist 170 to remove a part of the insulation layer 120". The embodiment is described by taking the hole slot of the at least one hole slot 121 approximately being an annular closed structure, namely, the hole slot of the at least one hole slot 121 corresponding to the whole edge of the die 130 (the first adhesive layer 140) as an example, therefore, in order to ensure that the hole slot of the at least one hole slot 121 is approximately arranged in a form of a rectangle as shown in FIG. 5, a patterned opening of the photoresist 170 may also be approximately rectangular. In other embodiments, when the at least one hole slot 121 in other arrangement forms needs to be formed, for example, the arrangement form of the hole slots of the at least one hole slot 121 as shown in FIG. 12, the patterned opening of the photoresist 170 may also be correspondingly adjusted, which is not limited to the embodiment.

Optionally, as shown in FIGS. 6 and 7, referring to FIG. 17, in the embodiment, the forming the second adhesive layer 122 may specifically include:
S300: applying drop coats of a buffer adhesive material into the at least one hole slot 121; and
S301: performing heating for baking, such that the buffer adhesive material is cured to form the second adhesive layer 122.

As shown in FIG. 6, FIG. 6 representatively shows a schematic structure of the semiconductor structure in the "applying drop coats of a buffer adhesive material into the at least one hole slot 121". In the above step, the semiconductor structure includes the substrate 110, the insulation layer 120 and the buffer adhesive material, the drop coats of the buffer adhesive material are being applied into the at least one hole slot 121 of the insulation layer 120. The buffer adhesive material may be filled in the at least one hole slot 121 in a drop coat applying manner via an adhesive coating device 300, so as to ensure that the at least one hole slot 121 may be sufficiently filled and to optimize the material uniformity and compactness of the second adhesive layer 122 formed by a subsequent process, thereby further improving the effect of optimizing the stress distribution. In other embodiments, the buffer adhesive material may also be filled in the at least one hole slot 121 in other coating manners, which is not limited to the embodiment.

As shown in FIG. 7, FIG. 7 representatively shows a schematic structure of the semiconductor structure in the "performing heating for baking, such that the buffer adhesive material is cured to form the second adhesive layer 122". In the above step, the semiconductor structure includes the substrate 110, the insulation layer 120 and the cured second adhesive layer 122. The second adhesive layer 122 is formed via heating and curing the buffer adhesive material filled in the at least one hole slot 121 by a heating device 400. The heating device 400 may be, for example, an oven and the like.

Optionally, as shown in FIGS. 8 and 9, in the embodiment, the arrangement of the die 130 may specifically include:
laminating the first adhesive layer 140 and the die 130 on the substrate 110; and
performing heating for baking, such that the first adhesive layer 140 is cemented between the die 130 and the substrate 110.

As shown in FIG. 8, FIG. 8 representatively shows a schematic structure of the semiconductor structure in the "laminating the first adhesive layer 140 and the die 130 on the substrate 110". In the above step, the semiconductor structure includes the substrate 110, the insulation layer 120, the second adhesive layer 122, the first adhesive layer 140 and the die 130. The first adhesive layer 140 is located on the surface of the insulation layer 120, the die 130 is located on the surface of the first adhesive layer 140, and the first adhesive layer 140 and the die 130 may be laminated on the surface of the substrate 110 (actually the insulation layer 120) via a pressing device 200.

As shown in FIG. 9, FIG. 9 representatively shows a schematic structure of the semiconductor structure in the "performing heating for baking, such that the first adhesive layer 140 is cemented between the die 130 and the substrate 110". In the above step, the semiconductor structure includes the substrate 110, the insulation layer 120, the second adhesive layer 122, the first adhesive layer 140 and the die 130. Via the heating of the heating device 500, the first adhesive layer 140 may cement the die 130 on the substrate 110.

Further, in the embodiment, for the "performing heating for baking, such that the buffer adhesive material is cured to form the second adhesive layer 122" and "performing heating for baking, such that the first adhesive layer 140 is cemented between the die 130 and the substrate 110", the heating device 400 and the heating device 500 in the above two steps may adopt a same heating device. On this basis, differed from the heating step of arranging the die 130 to cure the first adhesive layer 140, the performing heating for baking so as to cure and form the second adhesive layer 122 may also be understood as "pre-baking". Accordingly, via the "pre-baking", the second adhesive layer 122 can be formed via curing, and a loading device of the semiconductor structure can be pre-heated.

As shown in FIG. 10, FIG. 10 representatively shows a schematic structure of the semiconductor structure in the "bonding the die 130 with the substrate 110". In the above step, the semiconductor structure includes the substrate 110, the insulation layer 120, the second adhesive layer 122, the first adhesive layer 140, the die 130 and a bonding wire 150. The bonding wire 150 is connected between the die 130 and the substrate 110 to realize the bonding between the die 130 and the substrate 110.

As shown in FIG. 11, FIG. 11 representatively shows a schematic structure of the semiconductor structure in the "forming a packaging layer 160 on the surface of the insulation layer 120". In the above step, the semiconductor structure includes the substrate 110, the insulation layer 120, the second adhesive layer 122, the first adhesive layer 140, the die 130, the bonding wire 150 and the packaging layer 160. The packaging layer 160 is formed on the surface of the substrate 110, and internally packages each structure on the substrate 110, such as the first adhesive layer 140, the second adhesive layer 122, the die 130, the bonding wire 150 and the like.

To sum up, by arranging the at least one hole slot corresponding to the position of at least a part of the edge of the first adhesive layer at the insulation layer and arranging the second adhesive layer having the elasticity modulus smaller than the elasticity modulus of the first adhesive layer in the at least one hole slot, the semiconductor structure and the method of manufacturing the semiconductor structure proposed by the present disclosure can optimize the stress distribution of the edge where the die is connected with the substrate, such that the semiconductor structure is difficult to generate crack at the edge where the die is connected with the substrate during bending or deformation.

The present disclosure is described above with reference to several typical embodiments. It should be understood that the terms used herein are intended for illustration, rather than limiting. The present disclosure may be specifically implemented in many forms without departing from the essence of the present disclosure. Therefore, it should be understood that the above embodiments are not limited to any of the above-mentioned details, but should be broadly interpreted according to the scope defined by the appended claims. Therefore, any changes and modifications falling within the claims or the scope thereof should be covered by the appended claims.

## Claims

1. A semiconductor structure comprising a substrate (110), a die (130) and a first adhesive layer (140), wherein a surface of the substrate (110) is provided with an insulation layer (120); the die (130) is arranged on a surface of the insulation layer (120) via the first adhesive layer (140);
**characterised in that** the insulation layer (120) is provided with at least one hole slot (121), the hole slot being defined as a recess, trench or void in the insulation layer, with a geometry corresponding to an edge of the first adhesive layer; a position of the at least one hole slot (121) corresponds to at least a part of an edge of the first adhesive layer (140); a second adhesive layer (122) is arranged in the at least one hole slot (121); at least a part of a surface of the second adhesive layer (122) is connected with the first adhesive layer (140); and
an elasticity modulus of the second adhesive layer (122) is smaller than an elasticity modulus of the first adhesive layer (140).

2. The semiconductor structure according to claim 1, wherein the at least one hole slot (121) runs through the insulation layer (120).

3. The semiconductor structure according to claim 1, wherein one hole slot (121) of the at least one hole slot (121) is an annular closed structure, such that the one hole slot (121) of the at least one hole slot (121) corresponds to a whole edge of the first adhesive layer (140).

4. The semiconductor structure according to claim 3, wherein the first adhesive layer (140) is rectangular; the edge of the first adhesive layer (140) has four side edges; and the one hole slot (121) of the at least one hole slot (121) is arranged in a form of a rectangular ring.

5. The semiconductor structure according to claim 1, wherein on the surface of the substrate (110), an outer side edge of an orthographic projection of the at least one hole slot (121) is located outside an edge of an orthographic projection of the first adhesive layer (140).

6. The semiconductor structure according to claim 1, wherein on the surface of the substrate (110), an orthographic projection of the at least one hole slot (121) is fully covered by an orthographic projection of the first adhesive layer (140), such that a whole surface of the second adhesive layer (122) is connected with the first adhesive layer (140).

7. The semiconductor structure according to claim 6, wherein on the surface of the substrate (110), an outer side edge of the orthographic projection of the at least one hole slot (121) coincides with an edge of the orthographic projection of the first adhesive layer (140).

8. The semiconductor structure according to claim 1, wherein a notch width (d1) of the at least one hole slot (121) is 5%-10% of a width (d2) of the first adhesive layer (140).

9. The semiconductor structure according to claim 1, wherein the elasticity modulus of the second adhesive layer (122) is smaller than an elasticity modulus of the insulation layer (120); and the elasticity modulus of the second adhesive layer (122) is smaller than an elasticity modulus of the die (130).

10. The semiconductor structure according to claim 1, wherein a coefficient of thermal expansion of the second adhesive layer (122) is smaller than a coefficient of thermal expansion of the first adhesive layer (140); the coefficient of thermal expansion of the second adhesive layer (122) is smaller than a coefficient of thermal expansion of the insulation layer (120); and the coefficient of thermal expansion of the second adhesive layer (122) is smaller than a coefficient of thermal expansion of the die (130).

11. The semiconductor structure according to claim 1, wherein a bonding strength between the first adhesive layer (140) and the second adhesive layer (122) is smaller than a bonding strength between the first adhesive layer (140) and the die (130); and a bonding strength between the first adhesive layer (140) and the second adhesive layer (122) is smaller than a bonding strength between the first adhesive layer (140) and the insulation layer (120).

12. The semiconductor structure according to claim 1, wherein a material of the second adhesive layer (122) comprises silicone gel and epoxy resin adhesive.

13. A method of manufacturing a semiconductor structure, comprising:
providing a substrate (110), wherein a surface of the substrate (110) is provided with an insulation layer (120) (S100);
**characterised by** forming at least one hole slot (121) which runs through the insulation layer (120) on the insulation layer (120) (S101);
forming a second adhesive layer (122) in the at least one hole slot (121) (S102);
arranging a die (130) on a surface of the insulation layer (120) via a first adhesive layer (140), wherein a position of the at least one hole slot (121) corresponds to at least a part of an edge of the first adhesive layer (140), at least a part of a surface of the second adhesive layer (122) is connected with the first adhesive layer (140), and an elasticity modulus of the second adhesive layer (122) is smaller than an elasticity modulus of the first adhesive layer (140) (S103); and
forming a packaging layer (160) on the surface of the insulation layer (120), wherein the die (130) and the first adhesive layer (140) are packaged in the packaging layer (160) (S104).

14. The method of manufacturing a semiconductor structure according to claim 13, wherein the forming the at least one hole slot (121) comprises:
arranging a photoresist (170) on the surface of the insulation layer (120) (S200);
patterning the photoresist (170) (S201); and
performing exposure by using the patterned photoresist (170) and removing a part, not shielded by the photoresist (170), of the insulation layer (120), so as to form the at least one hole slot (121) (S202).

15. The method of manufacturing a semiconductor structure according to claim 13, wherein the forming the second adhesive layer comprises:
applying drop coats of a buffer adhesive material into the at least one hole slot (121) (S300); and
performing heating for baking, such that the buffer adhesive material is cured to form the second adhesive layer (122) (S301).

## Patentansprüche

1. Halbleiterstruktur, umfassend ein Substrat (110), einen Chip (130) und eine erste Klebeschicht (140), wobei eine Oberfläche des Substrats (110) mit einer Isolierschicht (120) versehen ist; der Chip (130) über die erste Klebeschicht (140) auf einer Oberfläche der Isolierschicht (120) angeordnet ist;
**dadurch gekennzeichnet, dass**
die Isolierschicht (120) mit mindestens einem Lochschlitz (121) versehen ist, der Lochschlitz als eine Aussparung, ein Graben oder ein Hohlraum in der Isolierschicht definiert ist, mit einer Geometrie, die einer Kante der ersten Klebeschicht entspricht; eine Position des mindestens einen Lochschlitzes (121) mindestens einem Teil einer Kante der ersten Klebeschicht (140) entspricht; eine zweite Klebeschicht (122) in dem mindestens einen Lochschlitz (121) angeordnet ist; mindestens ein Teil einer Oberfläche der zweiten Klebeschicht (122) mit der ersten Klebeschicht (140) verbunden ist; und
ein Elastizitätsmodul der zweiten Klebeschicht (122) kleiner ist als ein Elastizitätsmodul der ersten Klebeschicht (140).

2. Halbleiterstruktur nach Anspruch 1, wobei der mindestens eine Lochschlitz (121) durch die Isolierschicht (120) verläuft.

3. Halbleiterstruktur nach Anspruch 1, wobei ein Lochschlitz (121) des mindestens einen Lochschlitzes (121) eine ringförmige geschlossene Struktur ist, sodass der eine Lochschlitz (121) des mindestens einen Lochschlitzes (121) einer ganzen Kante der ersten Klebeschicht (140) entspricht.

4. Halbleiterstruktur nach Anspruch 3, wobei die erste Klebeschicht (140) rechteckig ist; die Kante der ersten Klebeschicht (140) vier Seitenkanten aufweist; und der eine Lochschlitz (121) des mindestens einen Lochschlitzes (121) in Form eines rechteckigen Rings angeordnet ist.

5. Halbleiterstruktur nach Anspruch 1, wobei sich auf der Oberfläche des Substrats (110) eine äußere Seitenkante einer orthografischen Projektion des mindestens einen Lochschlitzes (121) außerhalb einer Kante einer orthografischen Projektion der ersten Klebeschicht (140) befindet.

6. Halbleiterstruktur nach Anspruch 1, wobei auf der Oberfläche des Substrats (110) eine orthografische Projektion des mindestens einen Lochschlitzes (121) vollständig von einer orthografischen Projektion der ersten Klebeschicht (140) bedeckt ist, sodass eine gesamte Oberfläche der zweiten Klebeschicht (122) mit der ersten Klebeschicht (140) verbunden ist.

7. Halbleiterstruktur nach Anspruch 6, wobei auf der Oberfläche des Substrats (110) eine äußere Seitenkante der orthografischen Projektion des mindestens einen Lochschlitzes (121) mit einer Kante der orthografischen Projektion der ersten Klebeschicht (140) übereinstimmt.

8. Halbleiterstruktur nach Anspruch 1, wobei eine Kerbenbreite (d1) des mindestens einen Lochschlitzes (121) 5 %-10 % einer Breite (d2) der ersten Klebeschicht (140) beträgt.

9. Halbleiterstruktur nach Anspruch 1, wobei der Elastizitätsmodul der zweiten Klebeschicht (122) kleiner ist als ein Elastizitätsmodul der Isolierschicht (120); und der Elastizitätsmodul der zweiten Klebeschicht (122) kleiner ist als ein Elastizitätsmodul des Chips (130).

10. Halbleiterstruktur nach Anspruch 1, wobei ein Wärmeausdehnungskoeffizient der zweiten Klebeschicht (122) kleiner ist als ein Wärmeausdehnungskoeffizient der ersten Klebeschicht (140); der Wärmeausdehnungskoeffizient der zweiten Klebeschicht (122) kleiner ist als ein Wärmeausdehnungskoeffizient der Isolierschicht (120); und der Wärmeausdehnungskoeffizient der zweiten Klebeschicht (122) kleiner ist als ein Wärmeausdehnungskoeffizient des Chips (130).

11. Halbleiterstruktur nach Anspruch 1, wobei die Haftfestigkeit zwischen der ersten Klebeschicht (140) und der zweiten Klebeschicht (122) geringer ist als die Haftfestigkeit zwischen der ersten Klebeschicht (140) und dem Chip (130); und die Haftfestigkeit zwischen der ersten Klebeschicht (140) und der zweiten Klebeschicht (122) geringer ist als die Haftfestigkeit zwischen der ersten Klebeschicht (140) und der Isolierschicht (120).

12. Halbleiterstruktur nach Anspruch 1, wobei ein Material der zweiten Klebeschicht (122) Silikongel und Epoxidharzkleber umfasst.

13. Verfahren zum Herstellen einer Halbleiterstruktur, umfassend:
Bereitstellen eines Substrats (110), wobei eine Oberfläche des Substrats (110) mit einer Isolierschicht (120) versehen ist (S100);
**gekennzeichnet durch**
Ausbilden von mindestens einem Lochschlitz (121), der durch die Isolierschicht (120) auf der Isolierschicht (120) verläuft (S101);
Ausbilden einer zweiten Klebeschicht (122) in dem mindestens einen Lochschlitz (121) (S102);
Anordnen eines Chips (130) auf einer Oberfläche der Isolierschicht (120) über eine erste Klebeschicht (140), wobei eine Position des mindestens einen Lochschlitzes (121) mindestens einem Teil einer Kante der ersten Klebeschicht (140) entspricht, mindestens ein Teil einer Oberfläche der zweiten Klebeschicht (122) mit der ersten Klebeschicht (140) verbunden ist, und ein Elastizitätsmodul der zweiten Klebeschicht (122) kleiner ist als ein Elastizitätsmodul der ersten Klebeschicht (140) (S103); und
Ausbilden einer Dichtungsschicht (160) auf der Oberfläche der Isolierschicht (120), wobei der Chip (130) und die erste Klebeschicht (140) in der Dichtungsschicht (160) abgedichtet sind (S104).

14. Verfahren zum Herstellen einer Halbleiterstruktur nach Anspruch 13, wobei das Ausbilden des mindestens einen Lochschlitzes (121) Folgendes umfasst:
Anordnen einer Fotolackschicht (170) auf der Oberfläche der Isolierschicht (120) (S200);
Strukturieren der Fotolackschicht (170) (S201); und
Durchführen einer Belichtung unter Verwendung der strukturierten Fotolackschicht (170) und Entfernen eines nicht durch die Fotolackschicht (170) abgeschirmten Teils der Isolierschicht (120), um den mindestens einen Lochschlitz (121) auszubilden (S202).

15. Verfahren zum Herstellen der Halbleiterstruktur nach Anspruch 13, wobei das Ausbilden der zweiten Klebeschicht Folgendes umfasst:
Auftragen von Tropfenschichten eines Pufferklebstoffs in den mindestens einen Lochschlitz (121) (S300); und
Erhitzen zum Einbrennen, sodass der Pufferklebstoff ausgehärtet wird, um die zweite Klebeschicht (122) (S301) zu bilden.

## Revendications

1. Structure semi-conductrice comprenant un substrat (110), une matrice (130) et une première couche adhésive (140), dans laquelle une surface du substrat (110) est pourvue d'une couche isolante (120) ; la matrice (130) est disposée sur une surface de la couche isolante (120) par l'intermédiaire de la première couche adhésive (140) ;
**caractérisé en ce que**
la couche isolante (120) est pourvue d'au moins un trou en fente (121), le trou en fente étant défini comme un creux, une tranchée ou un vide dans la couche isolante, avec une géométrie correspondant à un bord de la première couche adhésive ; une position du au moins un trou en fente (121) correspond à au moins une partie d'un bord de la première couche adhésive (140) ; une deuxième couche adhésive (122) est disposée dans le au moins un trou en fente (121) ; au moins une partie d'une surface de la deuxième couche adhésive (122) est reliée à la première couche adhésive (140) ; et
un module d'élasticité de la seconde couche adhésive (122) est inférieur à un module d'élasticité de la première couche adhésive (140).

2. Structure semi-conductrice selon la revendication 1, dans laquelle au moins un trou en fente (121) traverse la couche d'isolation (120).

3. Structure semi-conductrice selon la revendication 1, dans laquelle un trou en fente (121) de l'au moins un trou en fente (121) est une structure fermée annulaire, de sorte que le trou en fente (121) de l'au moins un trou en fente (121) correspond à un bord entier de la première couche adhésive (140).

4. Structure semi-conductrice selon la revendication 3, dans laquelle la première couche adhésive (140) est rectangulaire ; le bord de la première couche adhésive (140) a quatre bords latéraux ; et le trou en fente (121) de l'au moins un trou en fente (121) est disposé sous la forme d'un anneau rectangulaire.

5. Structure semi-conductrice selon la revendication 1, dans laquelle, sur la surface du substrat (110), un bord latéral extérieur d'une projection orthographique de l'au moins un trou en fente (121) est situé à l'extérieur d'un bord d'une projection orthographique de la première couche adhésive (140).

6. Structure semi-conductrice selon la revendication 1, dans laquelle, sur la surface du substrat (110), une projection orthographique de l'au moins un trou en fente (121) est entièrement couverte par une projection orthographique de la première couche adhésive (140), de sorte qu'une surface entière de la deuxième couche adhésive (122) est reliée à la première couche adhésive (140).

7. Structure semi-conductrice selon la revendication 6, dans laquelle, sur la surface du substrat (110), un bord latéral extérieur de la projection orthographique de l'au moins un trou en fente (121) coïncide avec un bord de la projection orthographique de la première couche adhésive (140).

8. Structure semi-conductrice selon la revendication 1, dans laquelle la largeur de l'encoche (d1) de l'au moins un trou en fente (121) est de 5 % à 10 % de la largeur (d2) de la première couche adhésive (140).

9. Structure semi-conductrice selon la revendication 1, dans laquelle le module d'élasticité de la seconde couche adhésive (122) est inférieur au module d'élasticité de la couche isolante (120) ; et le module d'élasticité de la seconde couche adhésive (122) est inférieur au module d'élasticité de la matrice (130).

10. Structure semi-conductrice selon la revendication 1, dans laquelle le coefficient de dilatation thermique de la seconde couche adhésive (122) est inférieur au coefficient de dilatation thermique de la première couche adhésive (140) ; le coefficient de dilatation thermique de la seconde couche adhésive (122) est inférieur au coefficient de dilatation thermique de la couche isolante (120) ; et le coefficient de dilatation thermique de la seconde couche adhésive (122) est inférieur au coefficient de dilatation thermique de la matrice (130).

11. Structure semi-conductrice selon la revendication 1, dans laquelle une force de liaison entre la première couche adhésive (140) et la deuxième couche adhésive (122) est inférieure à une force de liaison entre la première couche adhésive (140) et la matrice (130) ; et une force de liaison entre la première couche adhésive (140) et la deuxième couche adhésive (122) est inférieure à une force de liaison entre la première couche adhésive (140) et la couche d'isolation (120).

12. Structure semi-conductrice selon la revendication 1, dans laquelle un matériau de la deuxième couche adhésive (122) comprend un gel de silicone et un adhésif à base de résine époxy.

13. Procédé de fabrication d'une structure semi-conductrice, comprenant :
fournir un substrat (110), dans lequel une surface du substrat (110) est pourvue d'une couche d'isolation (120) (S100) ;
**caractérisé par**
former au moins une fente (121) qui traverse la couche d'isolation (120) sur la couche d'isolation (120) (S101) ;
former une deuxième couche adhésive (122) dans l'au moins un trou en fente (121) (S102) ;
disposer une matrice (130) sur une surface de la couche isolante (120) via une première couche adhésive (140), dans laquelle une position de l'au moins un trou en fente (121) correspond à au moins une partie d'un bord de la première couche adhésive (140), au moins une partie d'une surface de la deuxième couche adhésive (122) est reliée à la première couche adhésive (140), et un module d'élasticité de la deuxième couche adhésive (122) est plus petit qu'un module d'élasticité de la première couche adhésive (140) (S103) ; et
former une couche d'emballage (160) sur la surface de la couche d'isolation (120), dans laquelle la matrice (130) et la première couche adhésive (140) sont emballées dans la couche d'emballage (160) (S104).

14. Procédé de fabrication d'une structure semi-conductrice selon la revendication 13, dans lequel la formation d'au moins un trou en fente (121) comprend :
disposer une résine photosensible (170) sur la surface de la couche isolante (120) (S200) ;
modeler la résine photosensible (170) (S201) ; et
effectuer une exposition en utilisant la résine photosensible à motifs (170) et en enlevant une partie, non protégée par la résine photosensible (170), de la couche d'isolation (120), de manière à former au moins un trou en fente (121) (S202).

15. Procédé de fabrication d'une structure semi-conductrice selon la revendication 13, dans lequel la formation de la seconde couche adhésive comprend :
appliquer des couches de gouttes d'un matériau adhésif tampon dans au moins un trou en fente (121) (S300) ; et
chauffer pour cuire, de sorte que le matériau adhésif tampon soit durci pour former la seconde couche adhésive (122) (S301).
